# EUROPEAN PATENT APPLICATION

(11) **EP 4 654 791 A1**
(43) Date of publication of application: **26.11.2025**
(21) Application number: 23923415.6
(22) Date of filing: 24.02.2023
(51) Int. Cl.: H10K 30/50

(54) **PRECURSOR, PEROVSKITE LIGHT-ABSORBING LAYER AND PREPARATION METHOD, PEROVSKITE CELL, AND ELECTRIC DEVICE**

(71) Applicant: Contemporary Amperex Future Energy Research Institute (Shanghai) Limited, Shanghai 201100 (CN); Contemporary Amperex Technology Co., Limited, Ningde, Fujian 352100 (CN); SHANGHAI JIAOTONG UNIVERSITY, Minhang District Shanghai 200240 (CN)
(72) Inventor: CHEN, Junchao, Shanghai 201100 (CN); CHEN, Chen, Shanghai 201100 (CN); WANG, Jianli, Shanghai 201100 (CN); MENG, Ke, Shanghai 201100 (CN); CHEN, Guodong, Shanghai 201100 (CN); GUO, Yongsheng, Shanghai 201100 (CN)
(74) Representative: Ziebig Hengelhaupt Intellectual Property Attorneys Patentanwaltskanzlei PartGmbB
(86) International application number: PCT/CN2023/078193
(87) International publication number: WO 2024/174239

(57) **Abstract**

Embodiments of this application provide a precursor, a perovskite light-absorbing layer, a preparation method thereof, a perovskite cell, and an electric device. A precursor is provided, used to prepare a perovskite light-absorbing layer, including: a perovskite precursor solution and an organic additive added to the perovskite precursor solution; where the organic additive contains a six-membered heterocyclic compound; and a heteroatom of the six-membered heterocyclic compound includes one or more of S, N, and Se. In this embodiment, an organic additive, specifically a six-membered heterocyclic compound, is added to the perovskite precursor solution to form a precursor for preparing the perovskite light-absorbing layer. This additive is used to regulate the quality of the formed perovskite light-absorbing layer, impeding interface reactions such as redox between the formed perovskite light-absorbing layer and the charge carrier transport layer. As a result, the interface stability between the perovskite light-absorbing layer and the charge carrier transport layer is enhanced, improving the photoelectric conversion efficiency and stability of the perovskite cell containing the perovskite light-absorbing layer, and extending the lifespan of the perovskite cell.

## Description

### TECHNICAL FIELD

This application relates to the field of battery technologies, and in particular, to a precursor, a perovskite light-absorbing layer, a preparation method thereof, a perovskite cell, and an electric device.

### BACKGROUND

A perovskite solar cell refers to a cell that uses a perovskite material as the light-absorbing layer material. Due to the significant performance advantages of the perovskite material, such as high light absorption coefficient, long carrier mobility, and direct and tunable optical bandgap, perovskite solar cells have attracted extensive attention and developed rapidly. Currently, the latest internationally certified highest photoelectric conversion efficiency (PCE) of perovskite solar cells has reached 25.7%, showcasing significant application value.

### SUMMARY

The main technical problem addressed by this application is the issue that the interface between the perovskite light-absorbing layer and the charge carrier transport layer is prone to reactions.

According to a first aspect, a precursor is provided, used to prepare a perovskite light-absorbing layer, including:
a perovskite precursor solution and an organic additive added to the perovskite precursor solution;
where the organic additive contains a six-membered heterocyclic compound; and a heteroatom of the six-membered heterocyclic compound includes one or more of S, N, and Se.

In this embodiment, an organic additive, specifically a six-membered heterocyclic compound, is added to the perovskite precursor solution to form a precursor for preparing the perovskite light-absorbing layer. This additive is used to regulate the quality of the formed perovskite light-absorbing layer, impeding interface reactions such as redox between the formed perovskite light-absorbing layer and the charge carrier transport layer. As a result, the interface stability between the perovskite light-absorbing layer and the charge carrier transport layer is enhanced, improving the photoelectric conversion efficiency and stability of the perovskite cell containing the perovskite light-absorbing layer, and extending the lifespan of the perovskite cell.

In some embodiments, the perovskite precursor solution includes a precursor solution of Cs_{(0-0.05)}FA_{(0.8-0.95)}MA_{(0-0.10)}PbI₃.

The above perovskite material is used in one or more embodiments of this application, resulting in a perovskite light-absorbing layer of high quality, and a perovskite cell containing this perovskite light-absorbing layer having high photoelectric conversion efficiency and stability.

In some embodiments, a concentration of Pb²⁺ in the perovskite precursor solution is 1 M-2 M.

In one or more embodiments of this application, any concentration of the perovskite precursor solution that can improve quality of the formed perovskite light-absorbing layer is within the protection scope of this application. In one or more embodiments, the concentration of Pb²⁺ in the perovskite precursor solution may be 1 M-2 M. When a perovskite precursor solution within this concentration range is used in a preparation process of the perovskite light-absorbing layer, an organic additive added to it can be uniformly dispersed, making the performance of the formed perovskite light-absorbing layer more uniform, which is conducive to enhancing the performance of the perovskite cell.

In some embodiments, a molar fraction of the organic additive relative to the perovskite precursor solution is 0.1%-10%.

In one or more embodiments of this application, any molar fraction of the organic additive relative to the perovskite precursor solution that can improve the quality of the formed perovskite light-absorbing layer is within the protection scope of this application. In one or more embodiments, the molar fraction of the organic additive relative to the perovskite precursor solution is in a range of 0.1%-10%, resulting in a high-quality perovskite light-absorbing layer that effectively impedes redox and other interface reactions between the formed perovskite light-absorbing layer and the charge carrier transport layer, thus enhancing the performance of the perovskite cell.

In some embodiments, the six-membered heterocyclic compound contains one or two of a -R(=O)₂- functional group and a -N⁺ functional group, where R includes S and/or Se.

When the six-membered heterocyclic compound in one or more embodiments of this application contains the above functional groups, it has a favorable effect on impeding redox and other interface reactions between the formed perovskite light-absorbing layer and the charge carrier transport layer. Specifically, this may be due to a reaction of -R(=O)₂- functional groups and/or -N⁺ functional groups with ions of a precursor material in the perovskite precursor solution, thereby regulating a crystallization process of the perovskite material, such that the interface between the formed perovskite light-absorbing layer and the charge carrier transport layer undergoes modification, thereby impeding redox and other interface reactions between the formed perovskite light-absorbing layer and the charge carrier transport layer, and enhancing the photoelectric conversion efficiency and stability of the perovskite cell containing the perovskite light-absorbing layer.

In some embodiments, the six-membered heterocyclic compound includes one or more of 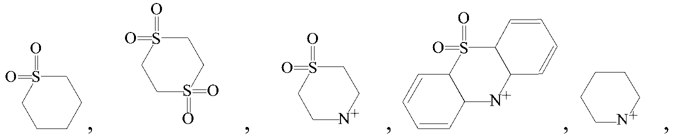 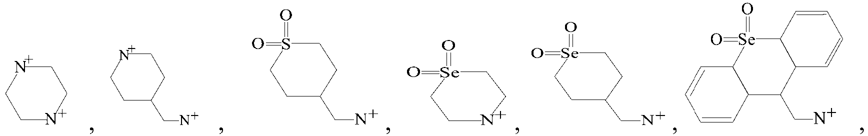 and

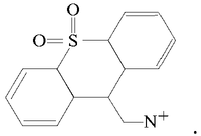

In one or more embodiments of this application, the formation of the perovskite light-absorbing layer is effectively regulated through the above organic additive, improving the quality of the formed perovskite light-absorbing layer, and enhancing the photoelectric conversion efficiency and stability of the perovskite cell containing the perovskite light-absorbing layer.

In some embodiments, the organic additive includes one or more of

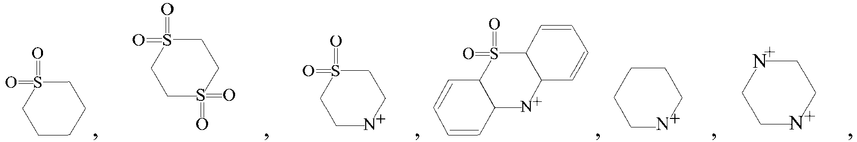

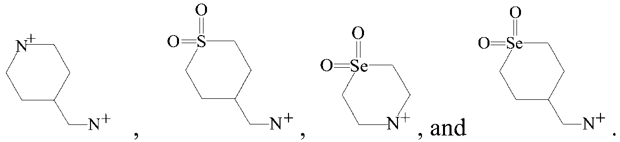

When the above organic additive provided in this embodiment is added to the perovskite precursor solution, a layered structure perovskite light-absorbing layer can be formed, thereby enhancing the photoelectric conversion efficiency and stability of the perovskite cell containing the perovskite light-absorbing layer.

In some embodiments, the organic additive includes one or more of 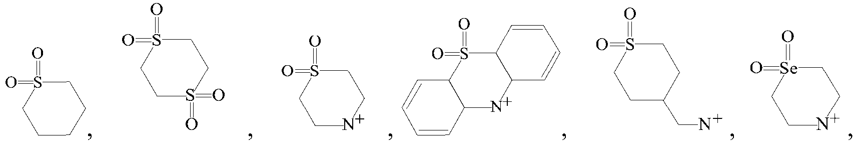 and

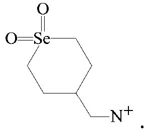

In this embodiment, some organic additives are provided, so that in the perovskite light-absorbing layer formed by the precursor, a two-dimensional perovskite layer is located between the three-dimensional perovskite layer and a buried interface, impeding interface reactions between the perovskite light-absorbing layer and the buried interface.

In some embodiments, the two-dimensional perovskite layer is located on a surface of the three-dimensional perovskite layer away from the buried interface BI, and the organic additive includes one or more of 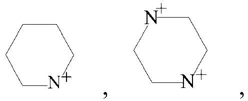 and

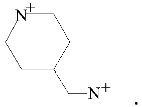

In this embodiment, some organic additives are provided, so that in the perovskite light-absorbing layer formed by the precursor, the two-dimensional perovskite layer is located on the surface of the three-dimensional perovskite layer away from the buried interface, impeding interface reactions between a functional layer in contact with the two-dimensional perovskite layer and the three-dimensional perovskite layer.

In some embodiments, the formed perovskite light-absorbing layer is a three-dimensional perovskite layer; and the organic additive includes one or two of

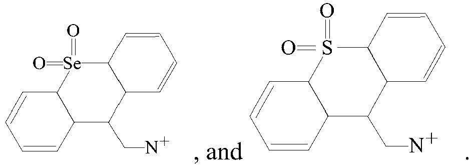

In this embodiment, some organic additives are provided, so that the precursor forms a perovskite light-absorbing layer containing only a three-dimensional perovskite layer, enhancing the photoelectric conversion efficiency of the perovskite cell containing the perovskite light-absorbing layer.

According to a second aspect, a perovskite light-absorbing layer is provided, prepared using any precursor provided in the first aspect.

In one or more embodiments of this application, the perovskite light-absorbing layer is prepared using any precursor provided in the first aspect, which is conducive to improving the quality and stability of the formed perovskite light-absorbing layer.

According to a third aspect, a method for preparing a perovskite light-absorbing layer is provided, where any precursor provided in the first aspect is applied on a surface of a buried interface BI, and a resulting product is annealed to form the perovskite light-absorbing layer.

In one or more embodiments of this application, a method for preparing a perovskite light-absorbing layer is provided, enabling any precursor provided in the first aspect of this application to form a perovskite light-absorbing layer with good quality and stability.

According to a fourth aspect, a perovskite cell is provided, including a perovskite light-absorbing layer; where the perovskite light-absorbing layer is the perovskite light-absorbing layer provided in the second aspect or the perovskite light-absorbing layer prepared by the method provided in the third aspect.

The perovskite cell provided in one or more embodiments of this application has high photoelectric conversion efficiency and stability.

In some embodiments, the perovskite cell is an inverted perovskite solar cell or a regular perovskite solar cell.

The perovskite light-absorbing layer provided in one or more embodiments of this application is suitable for both the regular perovskite solar cell and the inverted perovskite solar cell.

In some embodiments, the perovskite cell further includes a hole transport layer; the perovskite light-absorbing layer includes a two-dimensional perovskite layer and a three-dimensional perovskite layer; and the two-dimensional perovskite layer is formed between the three-dimensional perovskite layer and the hole transport layer.

In this embodiment, taking an inverted perovskite solar cell as an example, the two-dimensional perovskite layer is formed between the hole transport layer and the three-dimensional perovskite layer, impeding interface reactions between the three-dimensional perovskite layer and the hole transport layer, thereby improving the quality and stability of the formed perovskite light-absorbing layer.

In some embodiments, the hole transport layer is a metal oxide layer.

In this embodiment, the hole transport layer is a metal oxide layer. Its interface with the perovskite light-absorbing layer is prone to redox and other reactions, which can easily degrade the photoelectric conversion efficiency and stability of the perovskite cell. In this embodiment, through the placement of the two-dimensional perovskite layer between the three-dimensional perovskite layer and the metal oxide hole transport layer, interface reactions between the three-dimensional perovskite layer and the hole transport layer are further impeded, enhancing the photoelectric conversion efficiency and stability of the perovskite cell.

In some embodiments, the metal oxide is nickel oxide.

In this embodiment, through the placement of the two-dimensional perovskite layer between the three-dimensional perovskite layer and the nickel oxide hole transport layer, interface reactions between the three-dimensional perovskite light-absorbing layer and the hole transport layer can be further impeded, enhancing the photoelectric conversion efficiency and stability of the perovskite cell.

In some embodiments, a material of the perovskite light-absorbing layer includes Cs_{(0-0.05)}FA_{(0.8-0.95)}MA_{(0-0.10)}PbI₃.

In this embodiment, a specific material for the perovskite light-absorbing layer of a perovskite cell is provided.

In some embodiments, the two-dimensional perovskite layer and the three-dimensional perovskite layer are made of a same material.

In this embodiment, the two-dimensional perovskite layer and the three-dimensional perovskite layer are made of the same material such that interface reactions between the perovskite light-absorbing layer and the charge carrier transport layer are impeded, thereby improving the photoelectric conversion efficiency and stability of the perovskite cell.

According to a fifth aspect, an electric device is provided, including any perovskite cell provided in the fourth aspect.

### BRIEF DESCRIPTION OF DRAWINGS

To describe the technical solutions in the embodiments of this application more clearly, the following briefly describes the accompanying drawings required for describing the embodiments of this application. Apparently, the accompanying drawings in the following description show merely some embodiments of this application, and a person of ordinary skill in the art may still derive other drawings from the accompanying drawings without creative efforts.
FIG. 1 is a first schematic structural diagram of a perovskite light-absorbing layer provided in this application;
FIG. 2 is a second schematic structural diagram of a perovskite light-absorbing layer provided in this application;
FIG. 3 is a third schematic structural diagram of a perovskite light-absorbing layer provided in this application;
FIG. 4 is a schematic structural diagram of a perovskite cell prepared in this application;
FIG. 5 is a schematic structural diagram of a regular perovskite solar cell provided in this application; and
FIG. 6 is a schematic structural diagram of an inverted perovskite solar cell provided in this application.

In the accompanying drawings, the figures are not necessarily drawn to scale.

Reference signs are described as follows:
10 - conductive substrate, BI - buried interface, 20 - first transport layer, 30 - perovskite light-absorbing layer, 31 - two-dimensional perovskite layer, 32 - three-dimensional perovskite layer, 40 - second transport layer, 50 - metal electrode, 60 - organic additive, 100 - perovskite cell, HTL - hole transport layer, and ETL - electron transport layer.

### DESCRIPTION OF EMBODIMENTS

The following further describes implementations of this application in detail with reference to the accompanying drawings and embodiments. The detailed description of the embodiments and the accompanying drawings are intended to illustrate the principle of this application, rather than to limit the scope of this application, meaning this application is not limited to the embodiments described herein.

In the description of this application, it should be noted that, unless otherwise stated, "multiple" means at least two; and the orientations or positional relationships indicated by the terms "upper", "lower", "left", "right", "inside", "outside", and the like are merely for ease and brevity of description of this application rather than indicating or implying that the means or components mentioned must have specific orientations or must be constructed or manipulated according to particular orientations. These terms shall therefore not be construed as limitations on this application. In addition, the terms "first", "second", "third", and the like are merely for the purpose of description and shall not be understood as any indication or implication of relative importance. "Perpendicular" is not perpendicular in the strict sense but within an allowable range of error. "Parallel" is not strictly parallel, but within the allowable range of error.

The orientation terms appearing in the following description all are directions shown in the figures, and do not limit the specific structure of the application. In the description of this application, it should also be noted that unless otherwise specified and defined explicitly, the terms "mount", "connect", and "join" should be understood in their general senses. For example, they may refer to a fixed connection, a detachable connection, or an integral connection, and may refer to a direct connection or an indirect connection via an intermediate medium. Persons of ordinary skill in the art can understand specific meanings of these terms in this application as appropriate to specific situations.

Currently, to improve the photoelectric conversion efficiency and stability of perovskite solar cells, researchers have conducted extensive studies on the device structure, materials and modifications of functional layers, interface engineering, and other aspects of perovskite solar cells.

During the research and development process, the inventors noticed that the interface between the perovskite light-absorbing layer and the charge carrier transport layer is prone to redox reactions, which significantly affect the properties of the perovskite light-absorbing layer, thereby affecting the photoelectric conversion efficiency and stability of the perovskite solar cell, and further affecting the lifespan of the perovskite solar cell.

To solve the above problems, the inventors of this application provide a precursor. Through the addition of an organic additive containing a six-membered heterocyclic compound to the perovskite precursor solution, redox and other interface reactions between the formed perovskite light-absorbing layer and the charge carrier transport layer is impeded, enhancing the photoelectric conversion efficiency and stability of the perovskite cell.

Furthermore, the inventors of this application provide a perovskite light-absorbing layer with a layered structure. A layer near the charge carrier transport layer impedes interface reactions between a layer away from the charge carrier transport layer and the charge carrier transport layer, improving the photoelectric conversion efficiency and stability of the perovskite cell. Additionally, the layered structure of this application is made of a same material, which can further enhance the photoelectric conversion efficiency of the perovskite cell.

Furthermore, the inventors of this application provide a perovskite cell in which a layer of the perovskite light-absorbing layer near the hole transport layer impedes interface reactions between a layer away from the hole transport layer and the hole transport layer, thereby improving the photoelectric conversion efficiency and stability of the perovskite cell.

The technical solutions described in embodiments of this application are applicable to a precursor, a perovskite light-absorbing layer and a preparation method thereof, a perovskite cell, and an electric device. The perovskite cell disclosed in this application may be used for a perovskite tandem cell and a silicon-perovskite tandem cell. This is not limited in this application.

The following further describes this application in detail with reference to the accompanying drawings and embodiments.

According to a first aspect, this application provides a precursor for preparing a perovskite light-absorbing layer, including:
a perovskite precursor solution and an organic additive added to the perovskite precursor solution;
where the organic additive contains a six-membered heterocyclic compound; and a heteroatom of the six-membered heterocyclic compound includes one or more of S, N, and Se.

In one or more embodiments of this application, the "precursor" is a pre-product before the perovskite light-absorbing layer is obtained. The "perovskite light-absorbing layer" is a core part of the perovskite cell, used to absorb photon energy from sunlight, generate electron-hole pairs, and separate the electron-hole pairs into free electrons and holes under the action of a built-in electric field. The holes are collected by the conductive substrate through the hole transport layer, and the electrons are collected by the metal electrode. The conductive substrate and the metal electrode are connected to form a circuit to generate photocurrent. A material of the "perovskite light-absorbing layer" is a perovskite material. The perovskite material refers to a material with a same crystal structure as CaTiO₃, presenting a cubic crystal phase in a stable state. The "perovskite precursor solution" refers to a precursor raw material used to form the perovskite material. The "organic additive" is used to be added to the perovskite precursor solution to form the precursor, so as to improve the quality of the formed perovskite light-absorbing layer and impede redox and other interface reactions between the formed perovskite light-absorbing layer and the charge carrier transport layer, thereby enhancing the photoelectric conversion efficiency and stability of the perovskite cell. The "charge carrier transport layer" may be an electron transport layer or a hole transport layer. The "six-membered heterocyclic compound" refers to an organic compound containing a heterocyclic structure in the molecule, with six elements forming the ring. Besides the carbon element, it contains at least one heteroatom. In one or more embodiments of this application, the heteroatom includes one or more of S, N, and Se.

In this embodiment, an organic additive, specifically a six-membered heterocyclic compound, is added to the perovskite precursor solution to form a precursor for preparing the perovskite light-absorbing layer. This additive is used to regulate the quality of the formed perovskite light-absorbing layer, impeding interface reactions such as redox between the formed perovskite light-absorbing layer and the charge carrier transport layer. As a result, the interface stability between the perovskite light-absorbing layer and the charge carrier transport layer is enhanced, improving the photoelectric conversion efficiency and stability of the perovskite cell containing the perovskite light-absorbing layer, and extending the lifespan of the perovskite cell.

In one or more embodiments of this application, the organic additive is a six-membered heterocyclic compound; and a heteroatom of the six-membered heterocyclic compound includes one or more of S, N, and Se.

In some embodiments, the perovskite precursor solution may include a precursor solution of Cs_{(0-0.05)}FA_{(0.8-0.95)}MA_{(0-0.10)}PbI₃.

In this embodiment, Cs_{(0-0.05)}FA_{(0.8-0.95)}MA_{(0-0.10)}PbI₃ represents a perovskite material, where Cs represents cesium, FA represents formamidine, MA represents methylamine, Pb represents lead, and I represents iodine.

In this embodiment, a precursor solution of Cs_{(0-0.05)}FA_{(0.8-0.95)}MA_{(0-0.10)}PbI₃ may be composed of methylamine (CH₃NH₃⁺, MA⁺), inorganic cations (Cs⁺ or Rb⁺), divalent metal cations (Pb²⁺, Sn²⁺ or Ge²⁺), halide anions (I⁻), and so on.

The above perovskite material is used in one or more embodiments of this application, resulting in a perovskite light-absorbing layer of high quality, and a perovskite cell containing this perovskite light-absorbing layer having high photoelectric conversion efficiency and stability.

In some embodiments, a concentration of Pb²⁺ in the perovskite precursor solution is 1 M-2 M, to provide a specific concentration of Pb²⁺ in the perovskite precursor solution.

In one or more embodiments of this application, any concentration of the perovskite precursor solution that can improve quality of the formed perovskite light-absorbing layer is within the protection scope of this application. In one or more embodiments, the concentration of Pb²⁺ in the perovskite precursor solution may be 1 M-2 M. When a perovskite precursor solution within this concentration range is used in a preparation process of the perovskite light-absorbing layer, an organic additive added to it can be uniformly dispersed, making the performance of the formed perovskite light-absorbing layer more uniform, which is conducive to enhancing the performance of the perovskite cell.

In one or more embodiments of this application, a concentration of the perovskite precursor solution is a ratio of molar amounts of perovskite precursor materials to a molar volume of the perovskite precursor solvent.

Exemplarily, the concentration of Pb²⁺ in the perovskite precursor solution may be 1 M, 1.2 M, 1.4 M, 1.6 M, 1.8 M, and 2 M, and may also be 1.1 M, 1.3 M, 1.5 M, 1.7 M, 1.9 M, or the like, which is set reasonably as needed.

In some embodiments, a molar fraction of the organic additive relative to the perovskite precursor solution is 0.1%-10%.

In one or more embodiments of this application, any molar fraction of the organic additive relative to the perovskite precursor solution that can improve the quality of the formed perovskite light-absorbing layer is within the protection scope of this application. In one or more embodiments, the molar fraction of the organic additive relative to the perovskite precursor solution is in a range of 0.1%-10%, resulting in a high-quality perovskite light-absorbing layer that effectively impedes redox and other interface reactions between the formed perovskite light-absorbing layer and the charge carrier transport layer, thus enhancing the performance of the perovskite cell.

In one or more embodiments, the molar fraction of the organic additive relative to the perovskite precursor solution is a ratio of a molar amount of the organic additive to a molar amount of the perovskite precursor solution.

In some embodiments, the six-membered heterocyclic compound contains one or two of a -R(=O)₂- functional group and a -N⁺ functional group, where R includes S and/or Se.

The six-membered heterocyclic compounds provided in this embodiment may also contain the -R(=O)₂- functional group and the -N⁺ functional group to further define the specific molecular structure of the six-membered heterocyclic compound.

When the six-membered heterocyclic compound in one or more embodiments of this application contains the above functional groups, it has a favorable effect on impeding redox and other interface reactions between the formed perovskite light-absorbing layer and the charge carrier transport layer. Specifically, this may be due to a reaction of -R(=O)₂- functional groups and/or -N⁺ functional groups with ions of a precursor material in the perovskite precursor solution when a six-membered heterocyclic compound containing the -R(=O)₂- functional group and/or the -N⁺ functional group is added to the perovskite precursor solution, thereby regulating a crystallization process (for example, crystal grain growth orientation, and crystal grain size) of the perovskite material, such that the interface between the formed perovskite light-absorbing layer and the charge carrier transport layer undergoes modification (for example, passivation effect), thereby impeding redox and other interface reactions between the formed perovskite light-absorbing layer and the charge carrier transport layer, and enhancing the photoelectric conversion efficiency and stability of the perovskite cell containing the perovskite light-absorbing layer.

Exemplarily, the six-membered heterocyclic compound in one or more embodiments of this application may contain only a -S(=O)₂- functional group, a - Se(=O)₂- functional group, or a -N⁺ functional group. It may also contain two functional groups, such as a -S(=O)₂- functional group and a -N⁺ functional group, or a -Se(=O)₂-functional group and a -N⁺ functional group.

In some embodiments, the six-membered heterocyclic compound includes one or more of

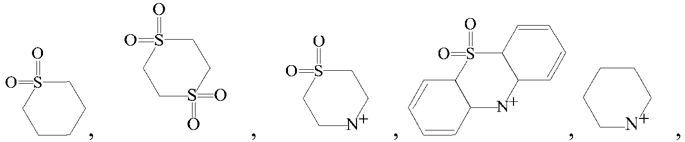

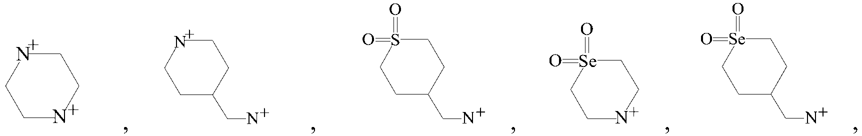

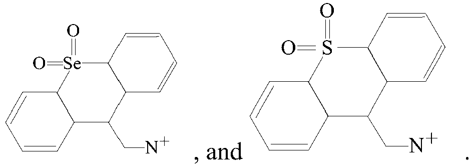

In one or more embodiments of this application, the formation of the perovskite light-absorbing layer is effectively regulated through the above organic additive, improving the quality of the formed perovskite light-absorbing layer, and enhancing the photoelectric conversion efficiency and stability of the perovskite cell containing the perovskite light-absorbing layer.

From the six-membered heterocyclic compound provided in one or more embodiments of this application, it can be seen that the six-membered heterocyclic compound may contain only one heteroatom, such as S, N, or Se. It may also contain only two heteroatoms, which may be a same element, such as two S atoms, or two N atoms, one S atom and one N atom, or one Se atom and one N atom.

In some embodiments, the organic additive includes one or more of

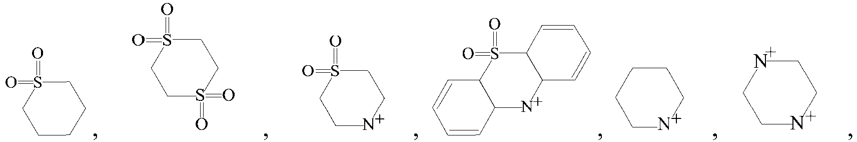

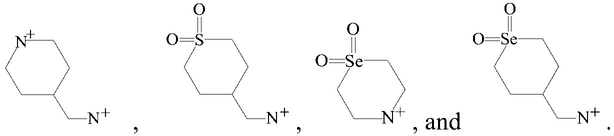

When the above organic additive provided in this embodiment is added to the perovskite precursor solution, a layered structure perovskite light-absorbing layer can be formed, thereby enhancing the photoelectric conversion efficiency and stability of the perovskite cell containing the perovskite light-absorbing layer. This may be because that in one or more embodiments of this application, a perovskite light-absorbing layer including a three-dimensional perovskite layer and a two-dimensional perovskite layer can be formed in one step, reducing crystallization defects of the perovskite light-absorbing layer and interface defects that may be generated during the formation of the layered structure, thereby improving the quality of the perovskite light-absorbing layer. In addition, the in-situ formed two-dimensional perovskite layer can also play a function of protecting the buried interface, impeding interface reactions between the perovskite light-absorbing layer and the charge carrier transport layer, and enhancing the interface stability of the charge carrier transport layer between the conductive substrate and the perovskite light-absorbing layer.

In some embodiments, the organic additive includes one or more of 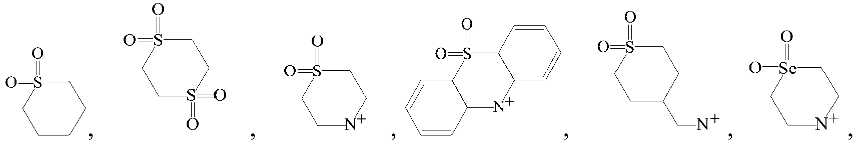 and

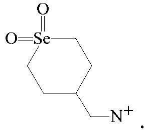

In this embodiment, some organic additives are provided, so that in the perovskite light-absorbing layer formed by the precursor, a two-dimensional perovskite layer is located between the three-dimensional perovskite layer and a buried interface, impeding interface reactions between the perovskite light-absorbing layer and the buried interface.

In some embodiments, the organic additive includes one or more of

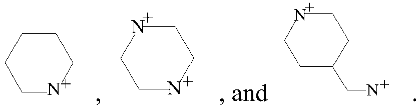

In this embodiment, some organic additives are provided, so that in the perovskite light-absorbing layer formed by the precursor, the two-dimensional perovskite layer is located on the surface of the three-dimensional perovskite layer away from the buried interface, impeding interface reactions between a functional layer in contact with the two-dimensional perovskite layer and the three-dimensional perovskite layer.

In some embodiments, the organic additive includes one or two of

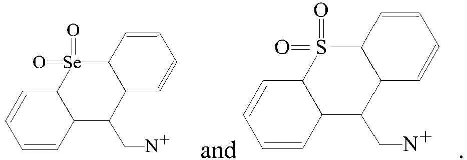

In this embodiment, some organic additives are provided, so that the precursor forms a perovskite light-absorbing layer containing only a three-dimensional perovskite layer, enhancing the photoelectric conversion efficiency of the perovskite cell containing the perovskite light-absorbing layer. This may be because that when an above organic additive is added to the perovskite precursor solution, its functional groups react with ions of a precursor material in the perovskite precursor solution, regulating a crystallization process (for example, crystal grain growth orientation, and crystal grain size) of the perovskite material, thereby improving the quality of the formed perovskite light-absorbing layer, which is conducive to enhancing the photoelectric conversion efficiency of the formed perovskite cell.

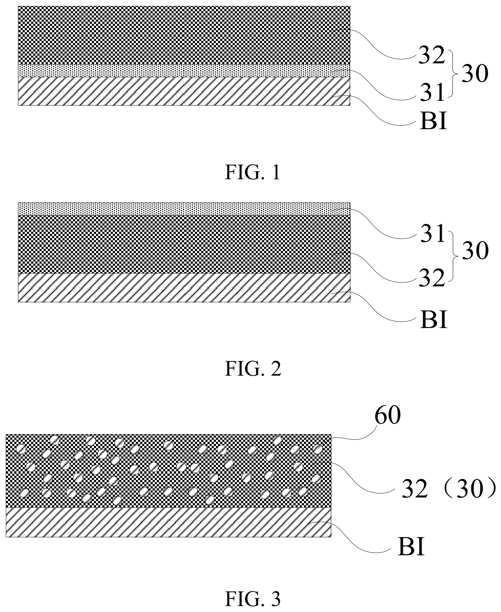

Refer to FIGs. 1 to 3. FIG. 1 is a first schematic structural diagram of a perovskite light-absorbing layer provided in this application. FIG. 2 is a second schematic structural diagram of a perovskite light-absorbing layer provided in this application. FIG. 3 is a third schematic structural diagram of a perovskite light-absorbing layer provided in this application.

According to a second aspect, in one or more embodiments of this application, a perovskite light-absorbing layer 30 is provided, prepared using any precursor provided in the first aspect.

Referring to FIG. 1, in this embodiment, a perovskite light-absorbing layer 30 is provided, including a two-dimensional perovskite layer 31 and a three-dimensional perovskite layer 32. The two-dimensional perovskite layer 31 is located between the three-dimensional perovskite layer 32 and the buried interface BI, impeding interface reactions between the three-dimensional perovskite layer 32 and the buried interface BI.

Referring to FIG. 2, in this embodiment, a perovskite light-absorbing layer 30 is provided, including a two-dimensional perovskite layer 31 and a three-dimensional perovskite layer 32. The two-dimensional perovskite layer 31 is located on a surface of the three-dimensional perovskite layer 32 away from the buried interface BI.

Referring to FIG. 3, in this embodiment, a perovskite light-absorbing layer 30 is provided, including only a three-dimensional perovskite layer 32. As shown in FIG. 3, the organic additive 60 is dispersed in the three-dimensional perovskite layer 32.

In one or more embodiments of this application, the perovskite light-absorbing layer 30 is prepared using any precursor provided in the first aspect, which improves the quality and stability of the formed perovskite light-absorbing layer 30.

According to a third aspect, a method for preparing a perovskite light-absorbing layer 30 is provided in one or more embodiments of this application, where any precursor provided in the first aspect is applied on a surface of a buried interface BI, and a resulting product is annealed to form the perovskite light-absorbing layer 30.

In one or more embodiments of this application, the "buried interface BI" represents a supporting structure for forming the perovskite light-absorbing layer 30. In one or more embodiments of this application, the buried interface BI may be an electron transport layer ETL or a hole transport layer HTL. "Annealing" refers to a heat treatment process in which a material is exposed to high temperatures for a period and then slowly cooled. In some embodiments, the annealing treatment process parameters for one or more embodiments of this application are: heat treatment at a temperature of 100°C to 150°C for 10 min to 30 min.

In one or more embodiments of this application, a method for preparing a perovskite light-absorbing layer 30 is provided, enabling any precursor provided in the first aspect of this application to form a perovskite light-absorbing layer 30 with good quality and stability.

The precursor provided in one or more embodiments of this application, for preparing a perovskite light-absorbing layer, includes:
a perovskite precursor solution and an organic additive added to the perovskite precursor solution;
where the organic additive is a six-membered heterocyclic compound; and a heteroatom of the six-membered heterocyclic compound includes one or more of S, N, and Se.

In some embodiments, a concentration of the perovskite precursor solution is 1 M-2 M.

In some embodiments, a molar fraction of the organic additive relative to the perovskite precursor solution is 0.1%-10%.

In some embodiments, the perovskite precursor solution may include a precursor solution of Cs_{(0-0.05)}FA_{(0.8-0.95)}MA_{(0-0.10)}PbI₃.

In some embodiments, the six-membered heterocyclic compound contains one or two of a -R(=O)₂- functional group and a -N⁺ functional group, where R is S and/or Se.

In some embodiments, the six-membered heterocyclic compound includes one or more of

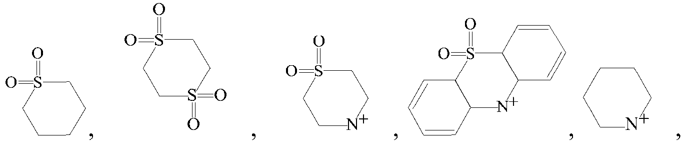

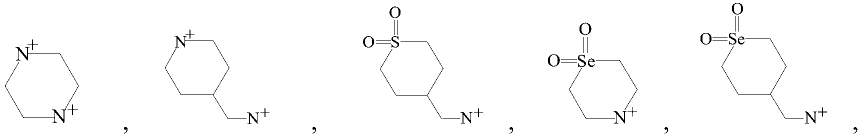

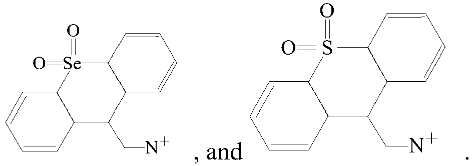

The perovskite light-absorbing layer 30 formed with the participation of the six-membered heterocyclic compound provided in this embodiment has a structure as shown in FIGs. 1 to 3. The perovskite cell containing the above perovskite light-absorbing layer 30 exhibits good photoelectric conversion efficiency and/or stability.

In some embodiments, the organic additive includes one or more of

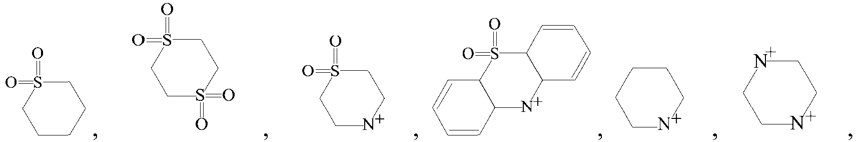

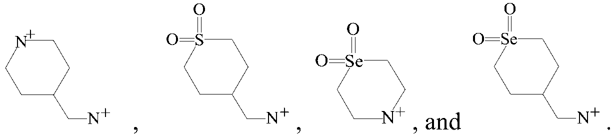

The perovskite light-absorbing layer 30 formed with the participation of the organic additive provided in this embodiment has a structure as shown in FIG. 1 or FIG. 2. The above perovskite light-absorbing layer 30 is divided into a two-dimensional perovskite layer 31 and a three-dimensional perovskite layer 32. The two-dimensional perovskite layer 31 is located between the three-dimensional perovskite layer 32 and the buried interface BI, or on the surface of the three-dimensional perovskite layer 32 away from the buried interface BI. The perovskite cell containing the above perovskite light-absorbing layer 30 exhibits good photoelectric conversion efficiency and/or stability.

In some embodiments, the organic additive includes one or more of 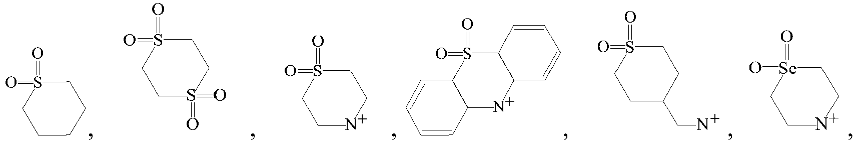 and

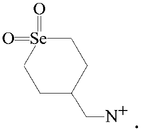

The perovskite light-absorbing layer 30 formed with the participation of the organic additive provided in this embodiment has a structure as shown in FIG. 1. The above perovskite light-absorbing layer 30 is divided into a two-dimensional perovskite layer 31 and a three-dimensional perovskite layer 32. The two-dimensional perovskite layer 31 is located between the three-dimensional perovskite layer 32 and the buried interface BI. The perovskite cell containing the above perovskite light-absorbing layer 30 exhibits good photoelectric conversion efficiency and stability.

In some embodiments, the organic additive includes one or more of

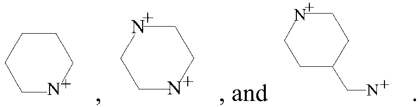

The perovskite light-absorbing layer 30 formed with the participation of the organic additive provided in this embodiment has a structure as shown in FIG. 2. The above perovskite light-absorbing layer 30 is divided into a two-dimensional perovskite layer 31 and a three-dimensional perovskite layer 32. The two-dimensional perovskite layer 31 is located on a surface of the three-dimensional perovskite layer 32 away from the buried interface BI. This is conducive to enhancing the stability of the perovskite cell containing the above perovskite light-absorbing layer 30.

In some embodiments, the organic additive includes one or two of

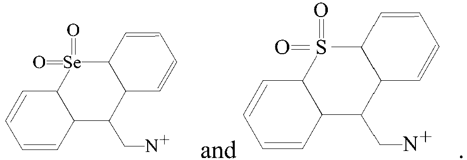

The perovskite light-absorbing layer 30 formed with the participation of the organic additive 60 provided in this embodiment has a structure as shown in FIG. 3. The above perovskite light-absorbing layer 30 consists solely of a three-dimensional perovskite layer 32. This is conducive to enhancing the photoelectric conversion efficiency and stability of the perovskite cell containing the above perovskite light-absorbing layer 30.

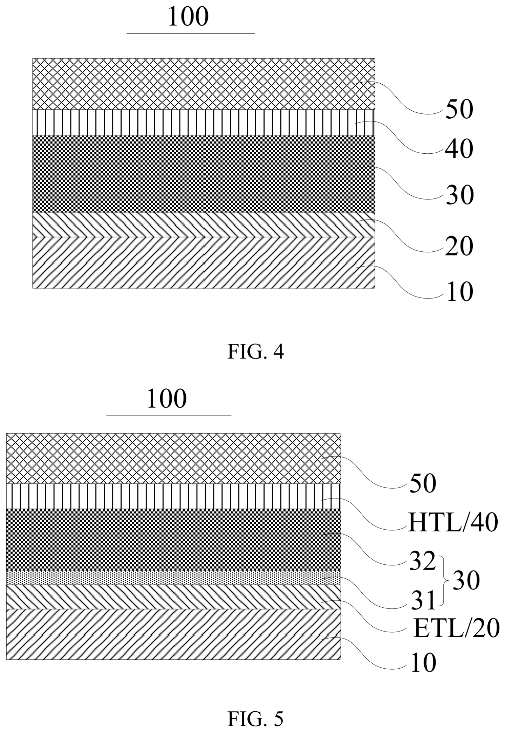

Referring to FIG. 4, FIG. 4 is a schematic structural diagram of a perovskite cell provided in this application.

According to a fourth aspect, referring to FIG. 4, in one or more embodiments of this application, a perovskite cell 100 is provided, including a perovskite light-absorbing layer 30. The perovskite light-absorbing layer 30 is the perovskite light-absorbing layer 30 provided in the second aspect or the perovskite light-absorbing layer 30 prepared by the method provided in the third aspect.

Still referring to FIG. 4, the perovskite cell 100 provided in one or more embodiments of this application includes a conductive substrate 10, a first transport layer 20, a perovskite light-absorbing layer 30, a second transport layer 40, and a metal electrode 50 which are sequentially arranged. One of the first transport layer 20 and the second transport layer 40 is a hole transport layer HTL, and the other is an electron transport layer ETL.

In one or more embodiments of this application, the "conductive substrate 10" represents an electrode with high conductivity and high visible light transmittance, serving as one output terminal of the perovskite cell 100, for example ITO conductive glass or FTO conductive glass. "First transport layer 20" and "second transport layer 40" represent structural layers that transport electrons or holes generated by the perovskite light-absorbing layer 30 when the perovskite light-absorbing layer 30 is excited by photons. "Metal electrode 50" represents an electrode made of metal, serving as another output terminal of the perovskite cell 100 device, requiring high conductivity and stability.

The perovskite cell 100 provided in one or more embodiments of this application has good photoelectric conversion efficiency and stability.

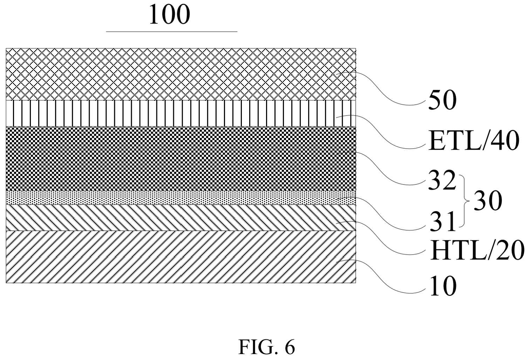

Referring to FIGs. 5 and 6, FIG. 5 is a schematic structural diagram of a regular perovskite solar cell provided in this application. FIG. 6 is a schematic structural diagram of an inverted perovskite solar cell provided in this application.

In some embodiments, the perovskite cell 100 is an inverted perovskite solar cell or a regular perovskite solar cell.

In this embodiment, referring to FIGs. 4 and 5, the first transport layer 20 is an electron transport layer ETL, and the second transport layer 40 is a hole transport layer HTL. The perovskite cell 100 containing them is a regular perovskite solar cell.

In this embodiment, referring to FIGs. 4 and 6, the first transport layer 20 is a hole transport layer HTL, and the second transport layer 40 is an electron transport layer ETL. The perovskite cell 100 containing them is an inverted perovskite solar cell.

The perovskite light-absorbing layer 30 provided in one or more embodiments of this application is suitable for both regular perovskite solar cells and inverted perovskite solar cells.

In some embodiments, referring to FIG. 6, the perovskite cell 100 further includes a hole transport layer HTL. The perovskite light-absorbing layer 30 includes a two-dimensional perovskite layer 31 and a three-dimensional perovskite layer 32. The two-dimensional perovskite layer 31 is formed between the three-dimensional perovskite layer 32 and the hole transport layer HTL.

In this embodiment, taking an inverted perovskite solar cell as an example, the two-dimensional perovskite layer 31 is formed between the hole transport layer HTL and the three-dimensional perovskite layer 32, impeding interface reactions between the three-dimensional perovskite layer 32 and the hole transport layer HTL, thereby improving the quality and stability of the formed perovskite light-absorbing layer 30.

In some embodiments, the hole transport layer HTL is a metal oxide layer.

In this embodiment, the hole transport layer HTL is a metal oxide layer. Its interface with the perovskite light-absorbing layer 30 is prone to redox and other reactions, which can easily degrade the photoelectric conversion efficiency and stability of the perovskite cell 100. In this embodiment, through the placement of the two-dimensional perovskite layer 31 between the three-dimensional perovskite layer 32 and the metal oxide hole transport layer HTL, interface reactions between the three-dimensional perovskite layer 32 and the hole transport layer HTL are further impeded, enhancing the photoelectric conversion efficiency and stability of the perovskite cell 100.

In some embodiments, the metal oxide is nickel oxide.

In this embodiment, nickel oxide is NiOₓ, a commonly used hole transport layer HTL material. In this embodiment, through the placement of the two-dimensional perovskite layer 31 between the three-dimensional perovskite layer 32 and the nickel oxide hole transport layer HTL, interface reactions between the three-dimensional perovskite light-absorbing layer 30 and the hole transport layer HTL can be further impeded, enhancing the photoelectric conversion efficiency and stability of the perovskite cell 100.

In some embodiments, a material of the perovskite light-absorbing layer includes Cs_{(0-0.05)}FA_{(0.8-0.95)}MA_{(0-0.10)}PbI₃.

In this embodiment, a specific material for the perovskite light-absorbing layer 30 of the perovskite cell 100 is provided.

In some embodiments, the two-dimensional perovskite layer and the three-dimensional perovskite layer are made of a same material.

In this embodiment, the two-dimensional perovskite layer 31 and the three-dimensional perovskite layer 32 are made of the same material. Compared to providing an interface structural layer of non-perovskite material between the three-dimensional perovskite layer 32 and the charge carrier transport layer, this can impede interface reactions between the perovskite light-absorbing layer 30 and the charge carrier transport layer, thereby improving the photoelectric conversion efficiency and stability of the perovskite cell 100.

According to a fifth aspect, in one or more embodiments of this application, an electric device is provided, including any perovskite cell 100 provided in the fourth aspect.

### Examples

In this application, organic additives No. 1 to No. 12 are provided, which are used to prepare corresponding inverted perovskite solar cells. The molecular structures of organic additives No. 1 to No. 12 are shown in Table 1.

**Table 1. Molecular structures of organic additives No. 1 to No. 12**

| Item | Molecular structure | Item | Molecular structure |
|---|---|---|---|
| No. 1 | 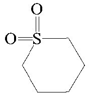 | No. 7 | 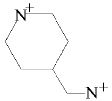 |
| No. 2 | 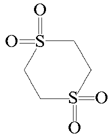 | No. 8 | 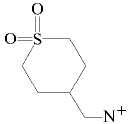 |
| No. 3 | 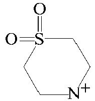 | No. 9 | 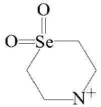 |
| No. 4 | 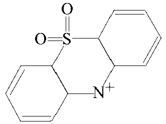 | No. 10 | 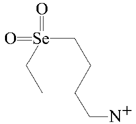 |
| No. 5 | 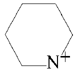 | No. 11 | 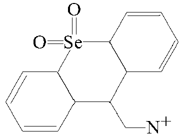 |
| No. 6 | 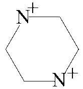 | No. 12 | 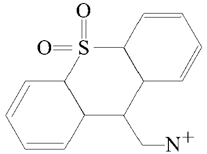 |

### Example 1

An inverted perovskite solar cell preparation method was provided in this example, including the following steps:
(1) The conductive substrate 10 was cleaned, and then a nickel oxide layer was formed on the cleaned surface of the conductive substrate 10 by magnetron sputtering. The nickel oxide layer served as the hole transport layer HTL and the first transport layer 20. The thickness of the first transport layer 20 in this example was 30 nm.
(2) Organic additive No. 1 was added to a perovskite precursor solution with a concentration of 1.4M for forming the Cs_{(0-0.05)}FA_{(0.8-0.95)}MA_{(0-0.10)}PbI₃ material. The perovskite precursor solution added with organic additive No. 1 was spin-coated on a surface of the first transport layer 20. The resulting product was annealed to form a perovskite light-absorbing layer 30 with a thickness of 450 nm. In this example, the molar fraction of organic additive No. 1 relative to the perovskite precursor solution was 5%. In this example, the annealing process specifically involves heat treatment at a temperature of 120°C for 30 min.
(3) PCBM (fullerene) and BCP (bathocuproine, hole blocking material) were spin-coated on a surface of the perovskite light-absorbing layer 30 to form an electron transport layer ETL with a thickness of 30 nm, serving as the second transport layer 40.
(4) A metal silver electrode with a thickness of 100 nm was thermally evaporated on a surface of the second transport layer 40 away from the conductive substrate 10, serving as the metal electrode 50.

The perovskite light-absorbing layer 30 formed in this example had a layered structure, referring to FIG. 1. The layered structure included a two-dimensional perovskite layer 31 and a three-dimensional perovskite layer 32, where the two-dimensional perovskite layer 31 was provided between the first transport layer 20 and the three-dimensional perovskite layer 32.

### Example 2

The preparation method of the inverted perovskite solar cell provided in this example differs from the preparation method provided in Example 1 in that:

Organic additive No. 2 was used in step (2).

The rest are the same as in Example 1.

### Example 3

The preparation method of the inverted perovskite solar cell provided in this example differs from the preparation method provided in Example 1 in that:

Organic additive No. 3 was used in step (2).

The rest are the same as in Example 1.

### Example 4

The preparation method of the inverted perovskite solar cell provided in this example differs from the preparation method provided in Example 1 in that:

Organic additive No. 4 was used in step (2).

The rest are the same as in Example 1.

### Example 5

The preparation method of the inverted perovskite solar cell provided in this example differs from the preparation method provided in Example 1 in that:

Organic additive No. 5 was used in step (2).

The rest are the same as in Example 1.

In the inverted perovskite solar cell formed in this example, as shown in FIG. 2, the two-dimensional perovskite layer 31 was placed between the three-dimensional perovskite layer 32 and the second transport layer 40 (which in this example was the electron transport layer ETL).

### Example 6

The preparation method of the inverted perovskite solar cell provided in this example differs from the preparation method provided in Example 5 in that:

Organic additive No. 6 was used in step (2).

The rest are the same as in Example 5.

### Example 7

The preparation method of the inverted perovskite solar cell provided in this example differs from the preparation method provided in Example 5 in that:

Organic additive No. 7 was used in step (2).

The rest are the same as in Example 5.

### Example 8

The preparation method of the inverted perovskite solar cell provided in this example differs from the preparation method provided in Example 1 in that:

Organic additive No. 8 was used in step (2).

The rest are the same as in Example 1.

### Example 9

The preparation method of the inverted perovskite solar cell provided in this example differs from the preparation method provided in Example 1 in that:

Organic additive No. 9 was used in step (2).

The rest are the same as in Example 1.

### Example 10

The preparation method of the inverted perovskite solar cell provided in this example differs from the preparation method provided in Example 1 in that:

Organic additive No. 10 was used in step (2).

The rest are the same as in Example 1.

### Example 11

The preparation method of the inverted perovskite solar cell provided in this example differs from the preparation method provided in Example 1 in that:

Organic additive No. 11 was used in step (2).

The rest are the same as in Example 1.

In the inverted perovskite solar cell formed in this example, as shown in FIG. 3, the perovskite light-absorbing layer 30 consists solely of a three-dimensional perovskite layer 32.

### Example 12

The preparation method of the inverted perovskite solar cell provided in this example differs from the preparation method provided in Example 11 in that:

Organic additive No. 12 was used in step (2).

The rest are the same as in Example 11.

### Example 13

The preparation method of the regular perovskite solar cell provided in this example differs from the preparation method provided in Example 5 in that:

Organic additive No. 5 was used in step (2).

The rest are the same as in Example 5.

In the regular perovskite solar cell formed in this example, as shown in FIG. 5, the two-dimensional perovskite layer 31 was placed between the three-dimensional perovskite layer 32 and the second transport layer 40 (which in this example was the hole transport layer HTL).

### Example 14

The preparation method of the regular perovskite solar cell provided in this example differs from the preparation method provided in Example 6 in that:

Organic additive No. 6 was used in step (2).

The rest are the same as in Example 6.

In the regular perovskite solar cell formed in this example, as shown in FIG. 5, the two-dimensional perovskite layer 31 was placed between the three-dimensional perovskite layer 32 and the second transport layer 40 (which in this example was the hole transport layer HTL).

### Example 15

The preparation method of the regular perovskite solar cell provided in this example differs from the preparation method provided in Example 7 in that:

Organic additive No. 7 was used in step (2).

The rest are the same as in Example 7.

In the regular perovskite solar cell formed in this example, as shown in FIG. 5, the two-dimensional perovskite layer 31 was placed between the three-dimensional perovskite layer 32 and the second transport layer 40 (which in this example was the hole transport layer HTL).

### Comparative Example 1

A preparation method of the inverted perovskite solar cell is provided in this comparative example, which differs from the preparation method provided in Example 1 in that:

No organic additive was added in step (2).

The rest are the same as in Example 1.

### Tests

The photoelectric conversion efficiency and stability of the perovskite cells 100 prepared in Examples 1 to 15 were tested, and the test results are shown in Table 2.

**Table 2. Photoelectric performance test results of the perovskite cells 100 provided in this application**

| Item | Photoelectric conversion efficiency | Rate of change in photoelectric conversion efficiency after 100 h of aging at 85°C. |
|---|---|---|
| Example 1 | 23.52% | -5% |
| Example 2 | 22.89% | -3% |
| Example 3 | 22.68% | -4% |
| Example 4 | 23.31% | -5% |
| Example 5 | 20.79% | -20% |
| Example 6 | 20.58% | -19% |
| Example 7 | 21% | -15% |
| Example 8 | 23.31% | -4% |
| Example 9 | 23.52% | -3% |
| Example 10 | 23.73% | -5% |
| Example 11 | 21.42% | -10% |
| Example 12 | 21.63% | -11% |
| Example 13 | 21.73% | -18% |
| Example 14 | 21.97% | -16% |
| Example 15 | 22.04% | -17% |
| Comparative Example 1 | 21% | -20% |

From the test results in Table 2, the following conclusions can be drawn:
(1) From the test results of Examples 1 to 4 and Examples 8 to 10 and the test results of Comparative Example 1, it can be seen that adding organic additives No. 1 to No. 4 or No. 8 to No. 10 during the preparation process of the perovskite light-absorbing layer 30 can significantly improve the photoelectric conversion efficiency and stability of the corresponding inverted perovskite solar cell. This may be related to the fact that the six-membered heterocycles of organic additives No. 1 to No. 4 or No. 8 to No. 10 at least contain one heteroatom of S or Se. The addition of organic additives of such a structure makes the formed perovskite light-absorbing layer 30 a layered structure, with the two-dimensional perovskite layer 31 located between the three-dimensional perovskite layer 32 and the hole transport layer HTL, thereby forming a functional layer in one step that impedes interface reactions between the three-dimensional perovskite layer 32 and the hole transport layer HTL, enhancing the photoelectric conversion efficiency and stability of the inverted perovskite solar cell.
(2) From the test results of Examples 5 to 7 and Examples 13 to 15, it can be seen that the photoelectric conversion efficiency and stability of the regular perovskite solar cell with the two-dimensional perovskite layer 31 located between the three-dimensional perovskite layer 32 and the hole transport layer HTL are higher than the photoelectric conversion efficiency and stability of the inverted perovskite solar cell with the two-dimensional perovskite layer 31 located between the three-dimensional perovskite layer 32 and the electron transport layer ETL.
(3) From the test results of Examples 11 to 12 and the test results of Comparative Example 1, it can be seen that adding organic additives No. 11 to No. 12 during the preparation process of the perovskite light-absorbing layer 30 improves the stability of the corresponding inverted perovskite solar cell to some extent, which may be related to the improved film quality of the perovskite light-absorbing layer 30 formed with the participation of organic additives No. 11 to No. 12.

Although this application has been described with reference to some preferred embodiments, various modifications to this application and replacements of the components therein with equivalents can be made without departing from the scope of this application. In particular, as long as there is no structural conflict, the various technical features mentioned in the embodiments can be combined in any manner. This application is not limited to the specific embodiments disclosed in this specification but includes all technical solutions falling within the scope of the claims.

## Claims

1. A precursor, used to prepare a perovskite light-absorbing layer, and **characterized by** comprising:
a perovskite precursor solution and an organic additive added to the perovskite precursor solution;
wherein the organic additive contains a six-membered heterocyclic compound; and a heteroatom of the six-membered heterocyclic compound comprises one or more of S, N, and Se.

2. The precursor according to claim 1, **characterized in that** the perovskite precursor solution comprises a precursor solution of Cs_{(0-0.05)}FA_{(0.8-0.95)}MA_{(0-0.10)}PbI₃.

3. The precursor according to claim 2, **characterized in that** a concentration of Pb²⁺ in the perovskite precursor solution is 1 M-2 M.

4. The precursor according to any one of claims 1 to 3, **characterized in that** a molar fraction of the organic additive relative to the perovskite precursor solution is 0.1%-10%.

5. The precursor according to any one of claims 1 to 4, **characterized in that** the six-membered heterocyclic compound contains one or two of a -R(=O)₂- functional group and a -N⁺ functional group, wherein R comprises S and/or Se.

6. The precursor according to claim 5, **characterized in that** the six-membered heterocyclic compound comprises one or more of

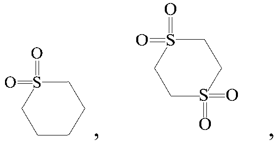

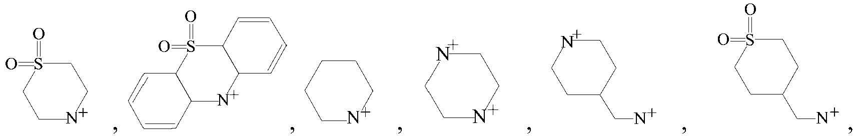

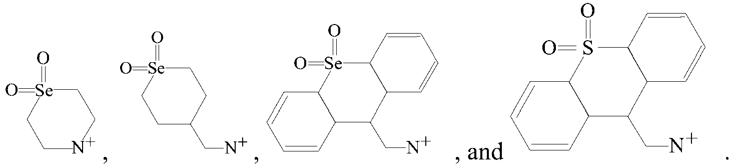

7. The precursor according to any one of claims 1 to 6, **characterized in that** the organic additive comprises one or more of 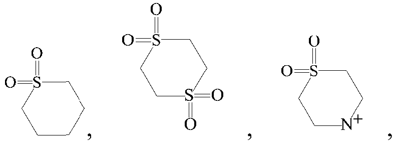 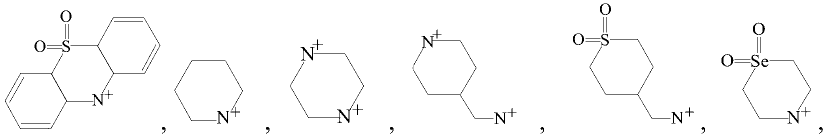 and

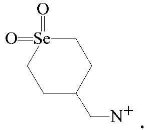

8. The precursor according to claim 7, **characterized in that** the organic additive comprises one or more of

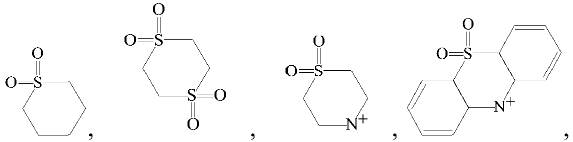

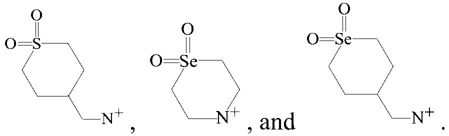

9. The precursor according to claim 7, **characterized in that** the organic additive comprises one or more of

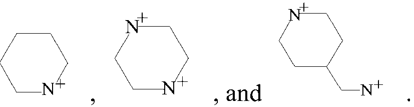

10. The precursor according to any one of claims 1 to 6, **characterized in that** the organic additive comprises one or two of

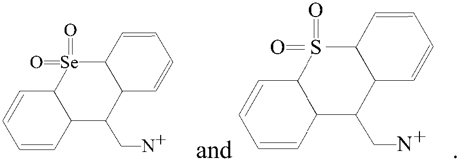

11. A perovskite light-absorbing layer, **characterized by** being prepared using the precursor according to any one of claims 1 to 10.

12. A method for preparing a perovskite light-absorbing layer, **characterized in that** the precursor according to any one of claims 1 to 10 is applied on a surface of a buried interface BI, and a resulting product is annealed to form the perovskite light-absorbing layer.

13. A perovskite cell, **characterized by** comprising a perovskite light-absorbing layer; wherein the perovskite light-absorbing layer is the perovskite light-absorbing layer according to claim 11 or the perovskite light-absorbing layer prepared by the method according to claim 12.

14. The perovskite cell according to claim 13, **characterized in that** the perovskite cell is an inverted perovskite solar cell or a regular perovskite solar cell.

15. The perovskite cell according to claim 13 or 14, **characterized in that** the perovskite cell further comprises a hole transport layer; the perovskite light-absorbing layer comprises a two-dimensional perovskite layer and a three-dimensional perovskite layer; and the two-dimensional perovskite layer is formed between the three-dimensional perovskite layer and the hole transport layer.

16. The perovskite cell according to claim 15, **characterized in that** the hole transport layer is a metal oxide layer.

17. The perovskite cell according to claim 16, **characterized in that** the metal oxide is nickel oxide.

18. The perovskite cell according to any one of claims 13 to 17, **characterized in that** a material of the perovskite light-absorbing layer comprises Cs_{(0-0.05)}FA_{(0.8-0.95)}MA_{(0-0.10)}PbI₃.

19. The perovskite cell according to any one of claims 15 to 18, **characterized in that** the two-dimensional perovskite layer and the three-dimensional perovskite layer are made of a same material.

20. An electric device, **characterized in that** the electric device comprises the perovskite cell according to any one of claims 13 to 19.
